(19) Europäisches Patentamt
European Patent Office
Office européen des brevets

(11) **EP 2 114 008 A1**

(12) **EUROPEAN PATENT APPLICATION**

(43) Date of publication:
**04.11.2009 Bulletin 2009/45**

(51) Int Cl.:
*H03F 1/30* (2006.01)     *H03F 1/32* (2006.01)
*H03F 3/30* (2006.01)

(21) Application number: **08155374.5**

(22) Date of filing: **29.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **VLSI Solution Oy**
**33720 Tampere (FI)**

(72) Inventors:
• **Hämäläinen, Ari**
  **33720 Tampere (FI)**
• **Ritoniemi, Tapani**
  **33720 Tampere (FI)**

(74) Representative: **Pursiainen, Timo Pekka et al**
**Tampereen Patenttitoimisto Oy**
**Hermiankatu 1 B**
**33720 Tampere (FI)**

(54) **A method for controlling an amplifier and an amplifier**

(57)   The invention relates to a method for controlling an amplifier (10). The method comprises inputting an audio signal; and providing the audio signal to an amplifying element (31a, 31 b) of an output stage (30) of the amplifier (10). The amplifying element (31 a, 31 b) comprises a control input (32a, 32b). In the method the current flowing through the amplifying element (31 a, 31 b) is measured, a control signal is generated on the basis of the measurement; and the control signal is provided to the control input (32a, 32b) of the amplifying element (31 a, 31 b). The invention also relates to an amplifier (10) in which the method is implemented.

Fig. 1

EP 2 114 008 A1

**Description**

Field of the Invention

The present invention relates to a method for controlling an amplifier and an amplifier which implements the method. The method comprises inputting an input signal, amplifying the input signal, and forming a control signal for a driver unit. The amplifier comprises an input, a control unit and a driver unit.

Background of the Invention

Amplifiers are used in many applications in which signal amplification is needed. The term audio amplifier means an amplifier which is intended to process signals which have a frequency in such a range which usually is audible by a human ear or near that frequency range. As a non-limiting example is a frequency range 20-20 000 Hz. Although the frequencies near the above mentioned limits are not audible by every human ear as such, those frequencies may affect to the quality of the audio signal a human experiences.

Another factor which may affect to the quality of the audio signal relates to the operation of the amplifier near zero-crossing points of the audio signal to be amplified. The zero-crossing point means a point in the signal in which the signal has a zero-value and changes the sign. In other words, the phase of the audio signal changes from positive to negative or vice versa. In a sine wave the zero-crossing point occurs twice during each cycle.

Amplifiers can be classified into several classes depending on the operation principle of the output stage of the amplifier. In class A the transistor(s) at the output stage of the amplifier conducts all the time i.e. for the complete cycle of the input signal. In class B the transistors at the output stage of the amplifier conduct only when the input signal is present and it's phase is positive (negative). When the input signal is absent or it's phase is negative (positive) practically no current flows through the output stage. Due to this nature a push-pull structure is needed wherein the output stage of the amplifier comprises separate circuits (transistors) for positive signal phases and for negative signal phases. At cross-over points one circuit becomes inactive (no current flowing through it) while the other circuit becomes conductive. Because a transistor is a non-linear component and needs a biasing voltage or a biasing current to operate, some distortion is generated when the input signal is near zero i.e. near the cross-over point. This cross-over distortion can be reduced by generating a small biasing voltage or current to the transistors of the output stage. Hence, the transistors will be conductive at small signal levels during the operation of the amplifier. This kind of an amplifier is usually classified as a Class AB amplifier. In class C the transistors at the output stage of the amplifier conduct less than half of the cycle i.e. only when the input signal is present and above a certain positive voltage level (or below a certain negative voltage level). When the input signal is absent or is near zero practically no current flows through the output stage. Also Class C amplifiers need a push-pull structure. The cross-over distortion is even worse in Class C amplifiers than in class B amplifiers.

Summary of the Invention

One aim of the present invention is to provide an improved method and an amplifier in which the cross-over distortion is reduced compared to prior art methods and amplifiers. The invention is based on the idea that a controlled bias is generated to the output stage of the amplifier. The bias control is based on the currents flowing through the transistors of the output stage. To put it more precisely, the method according to the invention is characterised by

- measuring the current flowing through the amplifying element;
- generating a control signal on the basis of the measurement; and
- providing the control signal to the control input of the amplifying element.

The amplifier according to the invention is characterised by that the amplifier comprises:

- measurement means for measuring a current flowing through the amplifying element;
- processing means for generating a control signal on the basis of the measurement; and
- controlling means for providing the control signal to the control input of the amplifying element

Some advantages can be achieved by the present invention. The operation of the output stage of the amplifier is less temperature dependent than output stages of amplifiers of prior art. It is also possible to utilize almost the whole supply voltage range i.e. the maximum output signal is near the supply voltage. The amplifier is also faster and more linear than prior art amplifiers.

Description of the Drawings

The invention will now be described in more detail with reference to the figures, in which

Fig. 1    depicts as a simplified block diagram an amplifier according to an example embodiment of the present invention;

Fig. 2    depicts some current wave forms in the amplifier according to an example embodiment of the present invention;

Fig. 3a    depicts currents of output stage transistors versus input voltage of a prior art Class AB amplifier;

Fig. 3b    depicts currents of output stage transistors versus input voltage of an amplifier according to an example embodiment of the present invention;

Fig. 4    depicts as a circuit diagram an amplifier according to an example embodiment of the present invention; and

Fig. 5    depicts as a block diagram a device in which the amplifier according to the present invention can be used.

Detailed Description of the Invention

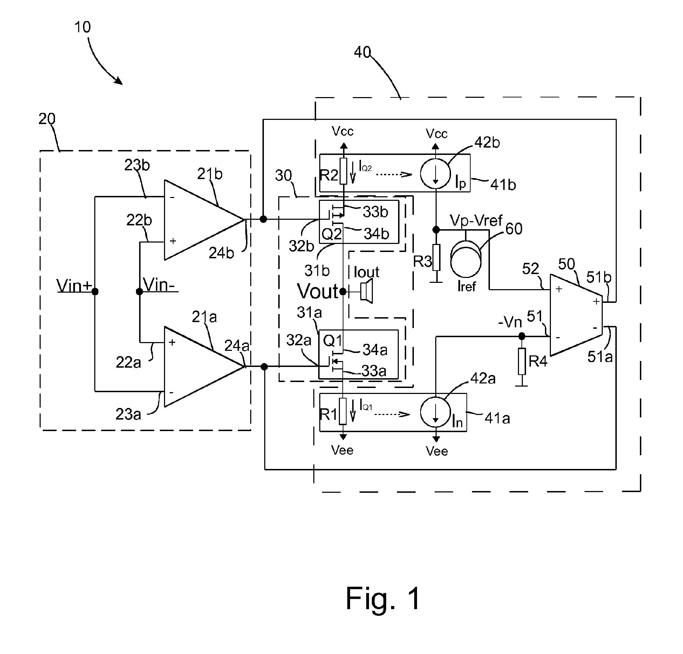

In Fig. 1 an example embodiment of an amplifier 10 according to the present invention is depicted as a simplified block diagram. The amplifier 10 comprises an input stage 20 for inputting an input signal. In this example embodiment the input stage 20 is a differential input stage comprising two pre-amplifiers 21a, 21b but it is obvious that also other kind of input stages can be used to provide the input signal to the amplifier 10. The input signal is provided to the negative inputs 22a, 22b and the positive inputs 23a, 23b of the pre-amplifiers 21a, 21b. The pre-amplifiers 21a, 21b amplify the input signal and perform a voltage-to-current transformation to the input signal. Hence, the first pre-amplifier 21a generates an output current at the output 24a of the first pre-amplifier 21a which is proportional to the voltage difference between the positive input 23a and the negative input 22a of the first pre-amplifier 21a. Respectively, the second pre-amplifier 21b generates an output current at the output 24b of the second pre-amplifier 21b which is also proportional to the voltage difference between the positive input 23b and the negative input 22b of the second pre-amplifier 21b.

The pre-amplifiers 21a, 21b are preferably transconductance amplifiers having high output impedance which makes it possible to combine signals as currents. In this example embodiment the output current of the first pre-amplifier 21a is combined (summed) with an output current of a bias control amplifier 50 and the output current of the second pre-amplifier 21b is combined (summed) with an inverted output current of the bias control amplifier 50 as will be explained later in this description.

The amplifier 10 further comprises an output stage 30. The output stage 30 is made of a first amplifying element 31a for driving towards negative direction and a second amplifying element 31b for driving towards positive direction of the amplified signal. Both the first amplifying element 31a and the second amplifying element 31b are inverting their input signal. Positive direction of the amplified input signal means in this description signal when the second amplifying element 31b drives towards the positive direction and, respectively, negative direction of the amplified input signal means signal when the first amplifying element 31a drives towards the negative direction. The output signal from the first pre-amplifier 21a i.e. the amplified input signal is connected to a control input 32a of the first amplifying element 31a. Respectively, the output signal from the second pre-amplifier 21b is connected to a control input 32b of the second amplifying element 31b.

The amplifying elements 31a, 31b are, for example, transistors such as mosfet transistors or bipolar transistors. The amplifying elements 31a, 31b should be selected as pairs in such a way that their operating characteristics are as complementary equal as possible. The first amplifying element 31a should be able to drive towards negative voltage supply and the second inverting amplifying element 31b should be able to drive towards positive voltage supply. Both amplifying elements should be able to handle as close to the supply rails as possible. As an example, the first amplifying element 31a could be an n-channel mosfet and the second amplifying element 31b could be a p-channel mosfet the characteristics of which correspond with the characteristics of the n-channel mosfet.

The first amplifying element 31a can be controlled by a voltage supplied at the control input 32a of the first amplifying element 31a and the second amplifying element 31b can be controlled by a voltage supplied at the control input 32b of the second amplifying element 31b. When the voltage at the control input 32a, 32b is smaller than a certain threshold value, the amplifying element 31a, 31b is switched off. When the voltage at the control input 32a, 32b exceeds the threshold value, the amplifying element 31a, 31b is switched on and a current flows through the amplifying element 31a, 31b. If the first amplifying element 31a is an n-channel mosfet the current flows from a drain 34a to a source 33a of the first amplifying element 31a and if the second amplifying element 31a is a p-channel mosfet the current flows from a source 33b to a drain 34b of the second amplifying element 31b.

The amplifier according to the present invention also comprises a control loop 40 for controlling the amplifying elements 31a, 31b. The control loop 40 comprises a first measurement block 41a and a second measurement block 41b. The first measurement block 41a measures the current $I_{Q1}$ flowing through the first amplifying element 31a and forms a first reference current In on the basis of the current $I_{Q1}$ flowing through the first amplifying element 31a. The measurement can be performed by, for example, the resistance R1 wherein the voltage across the resistance R1 is proportional to the current flowing through the resistance R1. The voltage is directed to a first current mirror 42a which generates a first reference current In which is proportional to the voltage across the resistance R1. Respectively, the second measurement block 41b, which comprises a second resistor R2 and a second current mirror 42b, measures the current $I_{Q2}$ flowing through the second amplifying element 31b and forms a second reference current Ip on the basis of the current $I_{Q2}$ flowing through the second amplifying element 31b.

In this example embodiment the relationship between the current flowing through the first amplifying element 31a and the current generated by the first current mirror 42a can be approximated by the following equation:

$$I_n = b, \text{when } I_{q1} \leq 0,$$
$$I_n = -a \cdot I_{q1} + b, \text{when } 0 < I_{q1} \leq b/a,$$
$$I_n = 0, \text{when } I_{q1} > b/a$$

$$(1a)$$

In the equation (1) a, b are factors which are set by parameters of the control loop. The relationship between the current flowing through the second amplifying element 31b and the current generated by the second current mirror 42b can be approximated by similar equation:

$$I_p = b, \text{when } I_{q2} \leq 0,$$
$$I_p = -a \cdot I_{q2} + b, \text{when } 0 < I_{q2} \leq b/a, \qquad (1b)$$
$$I_p = 0, \text{when } I_{q2} > b/a$$

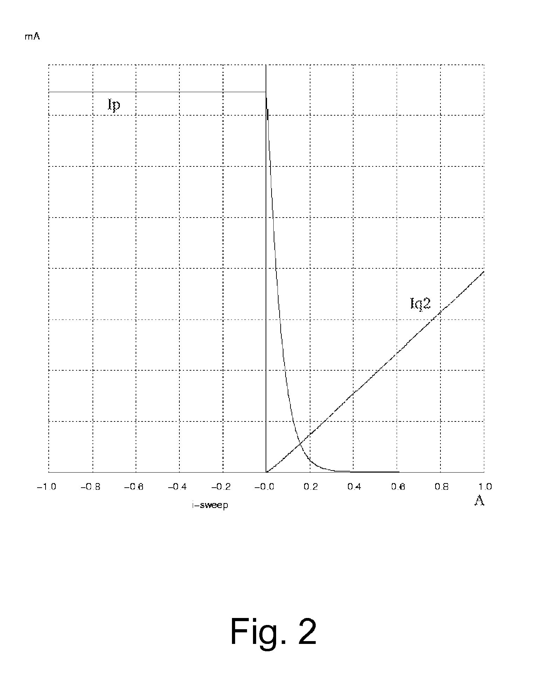

The waveforms of the second reference current Ip generated according to Equation (1b) and the current $I_{Q2}$ flowing through the second amplifying element 31b are depicted in Fig. 2. It should be noted that the graph depicting the current $I_{Q2}$ flowing through the second amplifying element 31b is scaled down in Fig. 2. It can be seen that when the value of the current $I_{Q2}$ flowing through the second amplifying element 31b is zero the second reference current Ip has a substantially constant value b. When the current $I_{Q2}$ flowing through the second amplifying element 31b begins to increase the second reference current Ip begins to decrease until the second reference current Ip reaches zero when the current $I_{Q2}$ has increased to a value b/a.

The first reference current In is converted to a first reference voltage by a resistance R4. This first reference voltage is input to a first input 51 of a bias control amplifier 50. A third reference current Iref is generated by a current generator 60 and subtracted from the second reference current Ip. The resulting current Ip-Iref is converted by a resistance R3 to a second reference voltage Vp-Vref, which is input to a second input 52 of the bias control amplifier 50. Preferably, the bias control amplifier 50 is also a transconductive amplifier having high output impedance to enable to combine signals as currents.

The third reference current determines the steady-state current of the output stage 30. The value of the third reference current is selected in such a way that it is smaller than the sum of the first reference current In and the second reference current Ip. Hence, a residual current remains which is used by the bias control amplifier 50 to adjust the voltage levels at the control inputs 32a, 32b of the amplifying elements 31a, 31b, for example the gate voltages of the mosfets Q1, Q2. The bias control amplifier 50 generates a bias control current at the second output 51b and an inverted bias control current at the first output 51a. The output current of the first pre-amplifier 21a is combined (summed) with the inverted bias control current of a bias control amplifier 50 and the output current of the second pre-amplifier 21b is combined (summed) with the bias control current of the bias control amplifier 50.

By using the current-based control system according to the invention the voltage levels at the control inputs 32a, 32b of the amplifying elements 31a, 31b are always such that both amplifying elements 31a, 31b are at a conducting stage. This improves and speeds up the operation of the amplifier because no time is needed for switching on the amplifying elements. Further, the loop gain of the amplifier of the present invention can be set to a high value to improve the linearity of the amplifier without loosing the stability of the amplifier.

The bias control amplifier 50 operates in such a manner that when the control loop is closed a balanced state can be achieved:

$$In+Ip-Iref = 0 \qquad\qquad (1c)$$

The current In is connected to the inverting input of the bias control amplifier 50. Hence, the sign of the current In is inverted. When combining the Equations (1a) and (1b) with the Equation (1c) we obtain

$$-a \cdot I_{q1} + b + -a \cdot I_{q2} + b = I_{ref}, \text{ when } 0 < I_{q1}, I_{q2} \leq b/a$$

at small signal levels.

When the amplifier is in a steady state $I_{q1}=Iq_2$. Hence $I_{q1}=I_{q2}=(2 \cdot b - I_{ref})/(2 \cdot a)$. When $I_{q1}>b/a$, the first mosfet Q1 drives the output and the second mosfet Q2 acts as a load. Therefore, using Equation (1c) we obtain $0-a \cdot I_{q2}+b=I_{ref}$ and the constant current through the second mosfet Q2 equals $I_{q2} =(b-I_{ref})/a$. Respectively, when $I_{q2}>b/a$, the second mosfet Q2 drives the output and the first mosfet Q1 acts as a load. Therefore, using Equation (1c) we obtain $(-a \cdot I_{q1}+b)+0=I_{ref}$ and the constant current through the first mosfet Q1 equals $I_{q1} =(b-I_{ref})/a$.

The bias control amplifier 50 connects differentially to both output stages whereas the pre-amplifiers 21a, 21b are in a common mode connection. This arrangement enables to connect the bias control amplifier 50 in such a way that it does not have any significant effect to the operation of the common mode connected pre-amplifiers 21a, 21b but only to the biasing of the output stages i.e. to the first 31a and second amplifying elements 31b.

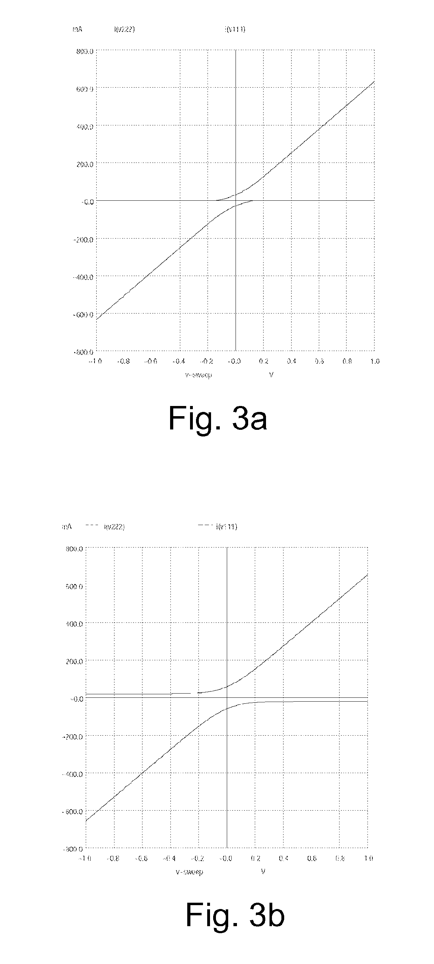

Fig. 3a depicts the current of the output stage of a prior art Class AB amplifier with respect to the input signal level. It can be seen that when the input signal is exceeding certain value the transistor is shutting off completely. That will cause distortion on such situations other transistor is turning on from the shutoff. There is significant delay from off state to conducting causing distortion in transitions and higher frequencies. This may be irritating and clearly audible especially at higher frequencies of the audio signal.

Fig. 3b depicts the current of the output stage of the amplifier according to the present invention with respect to the input signal level. It can be seen that the behaviour of the current of the output stage is not shutting off and thus have faster response to signal changes. This will produce less distortion in signal transitions and higher frequencies than in prior art amplifiers.

The output stage 30 of the amplifier 10 of Fig. 1 is a so-called common-source output stage i.e. the source of the first mosfet Q1 is connected to the negative supply voltage Vee (via the resistance R1) and the source of the second mosfet Q2 is connected to the positive supply voltage Vcc (via the resistance R2). The invention can also be implemented by using a so-called source follower output stage when the polarity of bias control amplifier is reversed due to different polarity of output stage. Hence, the drain of the first mosfet Q1 is connected to the negative supply voltage Vee and the drain of the second mosfet Q2 is connected to the positive supply voltage Vcc. In prior art systems the source-follower output stage needs an adjustable biasing circuit which should be temperature compensated. When the bias control loop according to the present invention is used, no temperature compensation is needed because the bias control loop also takes care of the temperature compensation.

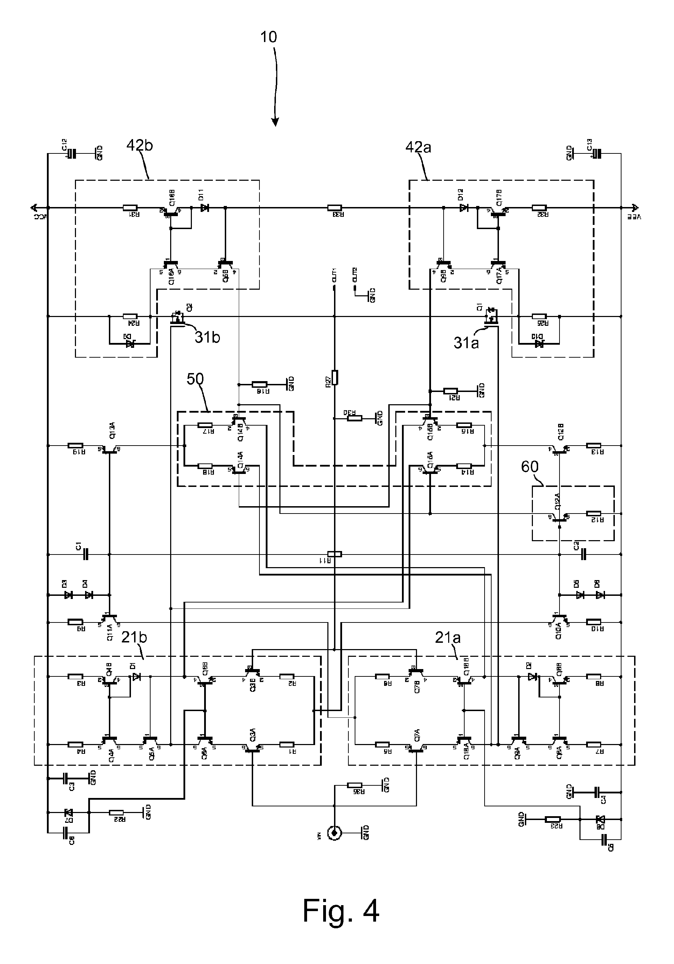

In the following the circuit diagram of Fig. 4 is described in more detail. The circuit diagram depicts an example implementation of the amplifier 10 according to the present invention. This amplifier 10 is implemented using bipolar transistors and mosfets to form the pre-amplifiers 21a, 21b, the output stage 30 and the bias control amplifier 50. The operation principle of this implementation follows the operation principles presented in connection with the disclosure of Fig. 1.

The first pre-amplifier 21a consists of the transistors Q18A, Q18B, Q7A, Q7B, Q8A, Q8B, Q9A, the diode D2 and the resistors R5-R8. The second pre-amplifier 21b consists of the transistors Q3A, Q3B, Q4A, Q4B, Q5A, Q6A, Q6B, the diode D1 and the resistors R1-R4. The input signal is connected to the base of the transistor Q3A and to the base of the transistor Q7A. These bases form the positive inputs of the pre-amplifiers 21a, 21b. The base of the transistor Q7B is used as the negative input of the first pre-amplifier 21a and the base of the transistor Q3B is used as the negative input of the second pre-amplifier 21b. The negative inputs of the pre-amplifiers 21a, 21b are connected to the common point of the resistors R27 and R30 which are connected in series between the output node OUT1 and the ground potential GND of the amplifier 10. The gain of the amplifier can therefore be determined by the ratio of the resistors R27 and R30 as follows:

$$Vout = \left(1 + \frac{R27}{R30}\right) \cdot Vin \qquad (2)$$

In the first pre-amplifier 21a the transistors Q8A, Q8B and Q9A, the diode D2 and the resistors R7, R8 operate as a current mirror. Respectively, In the second pre-amplifier 21b the transistors Q4A, Q4B and Q5A, the diode D1 and the resistors R3, R4 operate as a current mirror.

The output stage 30 of the amplifier 10 comprises the n-channel mosfet Q1 and the p-channel mosfet Q2. The output of the first pre-amplifier 21a, i.e. the interconnection of the collectors of the transistors Q18A and Q9A, is connected to the gate of the first mosfet Q1 and the output of the second pre-amplifier 21b, i.e. the interconnection of the collectors of the transistors Q6A and Q5A, is connected to the gate of the second mosfet Q2. The source of the n-channel mosfet Q1 is connected to the resistor R25 of the first measurement block 41a. The other end of the resistor R25 is connected to the negative supply voltage Vee. The source of the p-channel mosfet Q2 is connected to the resistor R24 of the second measurement block 41b and the other end of the resistor R24 is connected to the positive supply voltage Vcc.

The first measurement block 41a also comprises the first current mirror 42a and the schottky diode D10 connected over the resistor R25. The first current mirror 42a is formed of the transistors Q9B, Q17A and Q17B, the diode D12 and the resistor R32. The bases of the transistors Q17A and Q17B are connected together. The voltage level of the interconnected bases is set to a substantially fixed value. Therefore, when the voltage across the resistor R25 rises due to an increase in the current flowing through the n-channel mosfet Q1 of the output stage, the voltage between the base and the emitter of the transistor Q17A decreases thus decreasing the current flowing through the transistors Q17A and Q9B. This current flows also through the resistor R21. Therefore, the decrement of the current decreases the voltage drop across the resistor R21. The schottky diode D10 limits the voltage drop across the resistor R25 when the current flowing through the resistor R25 rises above a certain limit. Thus, the maximum output voltage of the output stage is defined by the threshold voltage of the schottky diode D10 and the channel resistance of the n-channel mosfet Q1. The threshold voltage of a schottky diode is typically about 0.3 V.

The ratio of the resistances of the resistors R25 and R32 determine the factor a of the Equation (1a) and the bias current of the second current mirror 42b is set by the resistance of the resistor R33 and the voltage over the resistor R33. This bias current determines the factor b of the Equation (1a).

The second measurement block 41b also comprises the second current mirror 42b and the schottky diode D9 connected over the resistor R24. The second current mirror 42b is formed of the transistors Q5B, Q16A and Q16B, the diode D11 and the resistor R31. The bases of the transistors Q16A and Q16B are connected together. The operation of the second measurement block 41b is analogous to the operation of the first measurement block 41a.

The ratio of the resistances of the resistors R24 and R31 determine the factor a of the Equation (1b) and the bias current of the second current mirror 42b is set by the resistance of the resistor R33 and the voltage over the resistor R33. This bias current determines the factor b of the Equation (1b).

The bias control amplifier 50 comprises a first pair of transistors Q15A and Q15B and a second pair of transistors Q14A and Q14B. These pairs of transistors Q15A; Q15B and Q14A; Q14B operate as differential amplifiers and they are cross-connected to each other. The output current of the first current mirror 42a i.e. the first reference current is connected to one input of both differential amplifiers, namely to the base of the transistors Q15B and Q14A and the output current of the second current mirror 42b i.e. the second reference current is connected to the other input of both differential amplifiers, namely to the base of the transistors Q15A and Q14B.

The transistor Q12A and the resistor R12 form the current generator 60 which generates the third reference current. The third reference current is converted to a voltage in the resistor R16 and this voltage is connected to the bases of the transistors Q15A and Q14B of the bias control amplifier 50. In the resistor R16 also the current generated by the second current mirror 42b is converted to voltage. In other words, the third reference current and the current generated by the second current mirror 42b are summed at the bases of the transistors Q15A and Q14B.

The first differential pair of transistors of the bias control amplifier 50 generates a first differential control current. On one side this current is connected from the collector of the transistor Q15A to the output of the second pre-amplifier 21b and on the other side this current is connected from the collector of the transistor Q15B to the current mirror of the second pre-amplifier 21b.

The second differential pair of transistors of the bias control amplifier 50 generates a second differential control current. On one side this current is connected from the collector of the transistor Q14A to the output of the first pre-amplifier 21a and on the other side this current is connected from the collector of the transistor Q14B to the current mirror of the first pre-amplifier 21a.

The bias control amplifier 50 uses the current mirrors of the pre-amplifiers 21a, 21b to convert differential control currents to one-sided control currents for the output stage.

The gain of the bias control amplifier 50 can be adjusted by the values of the resistances of the resistors R14; R15 and R17; R18.

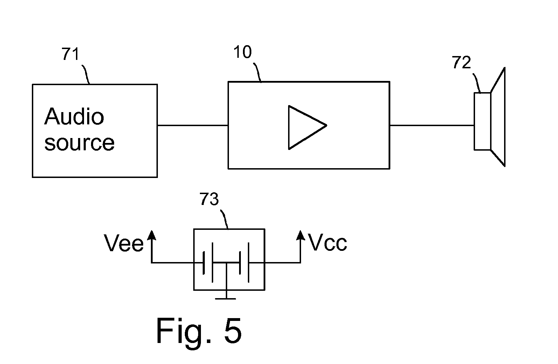

Fig. 5 depicts an example device 70 in which the amplifier of the present invention can be applied. The device 70 comprises an audio source 71 for producing an audio signal for the amplifier 10. The audio source 71 can be a microphone, a CDROM player, a DVD player, a radio receiver, for example. The audio signal is amplified by the amplifier 10 and connected to, for example, a loudspeaker 72. It should be noted that the device can comprise more than one audio source 71, amplifier 10 and loudspeaker 72. The power supply 73 generates the positive supply voltage Vcc and the negative supply voltage Vee for the device 70.

**Claims**

1. A method for controlling an amplifier (10) comprising:

   - inputting an audio signal;
   - providing the audio signal to an amplifying element (31a, 31b) of an output stage (30) of the amplifier (10), said amplifying element (31a, 31b) comprising a control input (32a, 32b);

   **characterised by**:

   - measuring the current flowing through the amplifying element (31a, 31b);
   - generating a control signal on the basis of the measurement; and
   - providing the control signal to the control input (32a, 32b) of the amplifying element (31a, 31b).

2. The method according to claim 1, **characterised in that** said output stage (30) is a push-pull output stage comprising:

   - a first amplifying element (31a) for driving amplified audio signal towards negative direction;
   - a second amplifying element (31b) for driving amplified audio signal towards positive direction,

   wherein the method comprises:

   - measuring the current flowing through the first amplifying element (31a); and
   - measuring the current flowing through the second amplifying element (31b);
   - generating a first reference current (In) on the basis of the current ($I_{Q1}$) flowing through the first amplifying element (31a);
   - generating a second reference current (Ip) on the basis of the current ($I_{Q2}$) flowing through the second amplifying element (31b); and
   - generating the control signal on the basis of said first reference current (In) and the second reference current (Ip).

3. The method according to claim 1 or 2, **characterised by** generating a third reference current (Iref), and generating the control signal on the basis of said first reference current (In), the second reference current (Ip), and the third reference current (Iref),

4. The method according to claim 3, **characterised in that** said third reference current (Iref) is smaller than the sum of the first (In) and the second reference current (Ip).

5. The method according to claims 3 or 4, **characterised in that** the amplifier (10) comprises a bias control amplifier (50), which is arranged to generate a bias control current in such a way that the sum operate in such a manner that the sum of the first reference current (In), the second reference current (Ip) and the third reference current (Iref) equals zero.

6. The method according to any of the claims 2 to 5, **characterised by** generating the first reference current (In) as follows:

$$I_n = b, \text{when } I_{q1} \leq 0,$$

$$I_n = -a \cdot I_{q1} + b, \text{ when } 0 < I_{q1} \leq b/a,$$

$$I_n = 0, \text{ when } I_{q1} > b/a$$

and generating the second reference current (Ip) as follows:.

$$I_p = b, \text{when } I_{q2} \leq 0,$$

$$I_p = -a \cdot I_{q2} + b, \text{ when } 0 < I_{q2} \leq b/a,$$

$$I_p = 0, \text{ when } I_{q2} > b/a$$

in which a, b are predetermined factors selected on the basis of characteristics of the first (31a) and second amplifying elements (31b).

7. An amplifier (10) comprising:

    - an input for inputting an audio signal;
    - means (20) for providing the audio signal to an amplifying element (31a, 31b) of an output stage (30) of the amplifier (10), said amplifying element (31a, 31b) comprising a control input (32a, 32b);

**characterised in that** the amplifier comprises:

    - measurement means (41a, 41b) for measuring a current flowing through the amplifying element (31a, 31b);
    - processing means (42a, 42b) for generating a control signal (In, Ip) on the basis of the measurement; and
    - controlling means (40) for providing the control signal to the control input (32a, 32b) of the amplifying element (31a, 31b).

8. The amplifier (10) according to claim 7, **characterised in that** said output stage (30) is a push-pull output stage comprising:

    - a first amplifying element (31a) for driving amplified audio signal towards negative direction;
    - a second amplifying element (31b) for driving amplified audio signal towards positive direction,

wherein said measurement means (41a, 41b) comprise

    - means (41a) for measuring the current flowing through the first amplifying element (31a); and
    - means (41b) for measuring the current flowing through the second amplifying element (31b); and

said processing means (42a, 42b) comprise

    - a first current mirror (42a) to generate a first reference current (In) on the basis of the current ($I_{Q1}$) flowing through the first amplifying element (31a); and
    - a second current mirror (42b) for generating a second reference current (Ip) on the basis of the current ($I_{Q2}$)

flowing through the second amplifying element (31b);

wherein said controlling means (40) are configured to generate the control signal on the basis of said first reference current (In) and the second reference current (Ip).

9. The amplifier (10) according to claim 7 or 8, **characterised in that** said controlling means (40) comprise means (60) for generating a third reference current (Iref), wherein said controlling means (40) are configured to generate the control signal on the basis of said first reference current (In), the second reference current (Ip), and the third reference current (Iref),

10. The amplifier (10) according to claim 9, **characterised in that** said third reference current (Iref) is smaller than the sum of the first (In) and the second reference current (Ip).

11. The amplifier (10) according to any of the claims 8 to 10, **characterised in that** the amplifier (10) comprises a bias control amplifier (50), which is arranged to generate a bias control current in such a way that the sum operate in such a manner that the sum of the first reference current (In), the second reference current (Ip) and the third reference current (Iref) equals zero.

12. The amplifier (10) according to any of the claims 8 to 11, **characterised in that** said first current mirror (42a) is configured to generate the first reference current (In) as follows:

$$I_n = b, \text{when } I_{q1} \leq 0,$$

$$I_n = -a \cdot I_{q1} + b, \text{when } 0 < I_{q1} \leq b/a,$$

$$I_n = 0, \text{when } I_{q1} > b/a$$

and said second current mirror (42b) is configured to generate the second reference current (Ip) as follows:.

$$I_p = b, \text{when } I_{q2} \leq 0,$$

$$I_p = -a \cdot I_{q2} + b, \text{when } 0 < I_{q2} \leq b/a,$$

$$I_p = 0, \text{when } I_{q2} > b/a$$

in which a, b are predetermined factors selected on the basis of characteristics of the first (31a) and second amplifying elements (31b).

Fig. 1

Fig. 2

Fig. 3a

Fig. 3b

Fig. 4

71

10

72

Audio
source

73

Vee↑  ↑Vcc

Fig. 5

Europäisches
Patentamt
European
Patent Office
Office européen
des brevets

**EUROPEAN SEARCH REPORT**

Application Number

EP 08 15 5374

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 143 375 A (THOMSON BRANDT GMBH [DE]) 5 June 1985 (1985-06-05) * pages 7,8; figure 3 * ----- | 1-4,7-10 | INV. H03F1/30 H03F1/32 H03F3/30 |
| X | DE 26 14 399 A1 (LENDER RUDOLF) 6 October 1977 (1977-10-06) * page 12, line 15 - page 14, line 15; figure 5 * ----- | 1-4,7,9, 10 | |
| X | US 4 237 425 A (SPIEGEL DAVID A) 2 December 1980 (1980-12-02) * column 8, line 15 - line 45; figure 7 * ----- | 1-4,7,9, 10 | |
| X | US 4 502 020 A (NELSON DAVID A [US] ET AL) 26 February 1985 (1985-02-26) * figure 2 * ----- | 1,2,7 | |
| X | US 4 121 168 A (STITT ROBERT M) 17 October 1978 (1978-10-17) * figure 2 * ----- | 1,2,7 | |
| A | US 6 433 637 B1 (SAUER DON R [US]) 13 August 2002 (2002-08-13) * figure 2 * ----- | 1,2,7 | TECHNICAL FIELDS SEARCHED (IPC) H03F |
| A | US 4 633 191 A (MALKA JACOB H [US] ET AL) 30 December 1986 (1986-12-30) * column 3, line 20 - line 30; figure 1 * ----- | 1,2,7 | |
| A | US 4 871 980 A (GULCZYNSKI ZDZISLAW [US]) 3 October 1989 (1989-10-03) * the whole document * ----- | 1-12 | |

The present search report has been drawn up for all claims

| Place of search | Date of completion of the search | Examiner |
|---|---|---|
| Munich | 27 October 2008 | Kurzbauer, Werner |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**　　EP 08 15 5374

This annex lists the patent family members relating to the patent documents cited in the above-mentioned European search report.
The members are as contained in the European Patent Office EDP file on
The European Patent Office is in no way liable for these particulars which are merely given for the purpose of information.

27-10-2008

| Patent document cited in search report | | Publication date | Patent family member(s) | | Publication date |
|---|---|---|---|---|---|
| EP 0143375 | A | 05-06-1985 | DE | 3343110 C1 | 30-05-1985 |
| | | | HK | 10196 A | 26-01-1996 |
| | | | JP | 1866374 C | 26-08-1994 |
| | | | JP | 5080843 B | 10-11-1993 |
| | | | JP | 60198907 A | 08-10-1985 |
| DE 2614399 | A1 | 06-10-1977 | NONE | | |
| US 4237425 | A | 02-12-1980 | NONE | | |
| US 4502020 | A | 26-02-1985 | DE | 3481798 D1 | 03-05-1990 |
| | | | EP | 0148563 A1 | 17-07-1985 |
| | | | JP | 61005608 A | 11-01-1986 |
| US 4121168 | A | 17-10-1978 | DE | 2836914 A1 | 08-03-1979 |
| | | | FR | 2401548 A1 | 23-03-1979 |
| | | | GB | 2003352 A | 07-03-1979 |
| | | | JP | 1372110 C | 07-04-1987 |
| | | | JP | 54045557 A | 10-04-1979 |
| | | | JP | 61036407 B | 18-08-1986 |
| US 6433637 | B1 | 13-08-2002 | NONE | | |
| US 4633191 | A | 30-12-1986 | NONE | | |
| US 4871980 | A | 03-10-1989 | NONE | | |

EPO FORM P0459

For more details about this annex : see Official Journal of the European Patent Office, No. 12/82